(19) Europäisches Patentamt
European Patent Office
Office européen des brevets

(11) **EP 4 682 957 A1**

(12) **EUROPEAN PATENT APPLICATION**
published in accordance with Art. 153(4) EPC

(43) Date of publication:
**21.01.2026 Bulletin 2026/04**

(21) Application number: **24770694.8**

(22) Date of filing: **07.03.2024**

(51) International Patent Classification (IPC):
**H01L 25/07** (2006.01)   **H01L 23/28** (2006.01)

(52) Cooperative Patent Classification (CPC):
**H01L 23/28; H01L 25/07**

(86) International application number:
**PCT/JP2024/008710**

(87) International publication number:
**WO 2024/190588 (19.09.2024 Gazette 2024/38)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **14.03.2023   JP 2023039354**

(71) Applicant: **Shindengen Electric Manufacturing Co., Ltd.**
**Tokyo 100-0004 (JP)**

(72) Inventors:
• **INABA Hayato**
**Asaka-shi Saitama 351-0015 (JP)**
• **IKEDA Takashi**
**Asaka-shi Saitama 351-0015 (JP)**
• **KUWANO Ryoji**
**Asaka-shi Saitama 351-0015 (JP)**

(74) Representative: **AOMB Polska Sp. z.o.o.**
**ul. Rondo Ignacego Daszynskiego 1**
**00-843 Warsaw (PL)**

(54) **SEMICONDUCTOR MODULE**

(57)    [Problem] The purpose is to provide a semiconductor module in which a case is reinforced and warpage can be suppressed by providing a plurality of ribs extending from ends of a terminal block. [Solution] In a semiconductor module 1 according to the present invention, a case 20 is attached in an annular manner around an edge 11 of a substrate 10. The semiconductor module 1 is characterized in that the case 20 has a terminal block 30, inner ribs 50, outer ribs 60, and intermediate ribs 70, and a plurality of inner ribs 50, a plurality of outer ribs 60, and a plurality of intermediate ribs 70 are provided so as to extend from the terminal block 30.

FIG. 1

**Description**

## TECHNICAL FIELD

The present invention relates to a semiconductor module, and in particular to a semiconductor module in which a case is attached in an annular manner around the edge of a substrate.

## BACKGROUND

A semiconductor module is formed by bonding a case to a substrate. Further, liquid resin is injected inside the case for resin-sealing of components arranged on the substrate. If the case undergoes deformation such as warpage, a gap is formed between the case and the substrate, which reduces the adhesive performance. Therefore, in order to prevent warpage, a rib structure in which predetermined ribs are provided for reinforcement may be adopted.

An example of such a rib structure of a semiconductor module is disclosed in Patent Document 1.

## PRIOR ART DOCUMENT

## PATENT DOCUMENT

Patent Document 1: JP 2008-153313 A

## SUMMARY OF THE INVENTION

## PROBLEMS TO BE SOLVED BY THE INVENTION

The rib structure of the above-mentioned semiconductor module consists of a single rib provided in a frame shape. In recent years, however, the performance of semiconductors has been required to be improved. As a result, the amount of information processing has become enormous, and warpage due to thermal displacement, etc. has tended to increase.

The present invention has been made in view of the above circumstances, and an object thereof is to provide a semiconductor module in which a plurality of ribs are provided extending from ends of a terminal block so that the case can be reinforced to suppress warpage.

## MEANS FOR SOLVING THE PROBLEMS

In order to achieve the above object, the semiconductor module according to the present invention is a semiconductor module having a case and a substrate, the case being attached in an annular manner around an edge of the substrate,

in which the case has a terminal block and ribs, and

in which a plurality of ribs are provided on the case to extend from the terminal block.

According to the present invention, the plurality of the ribs are provided on the case to extend from the terminal block. This makes it possible to reinforce the case and suppress warpage.

The ribs have at least one of a plurality of inner ribs, a plurality of outer ribs, and a plurality of intermediate ribs,

in which the plurality of inner ribs are provided at an inner edge of the case to extend from inner ends of the terminal block,

in which the plurality of outer ribs are provided at an outer edge of the case to extend from outer ends of the terminal block, and

in which the plurality of intermediate ribs are provided to extend from intermediate ends of the terminal block. This makes it possible to reinforce at least one of the inner, outer, and intermediate portions of the case.

The inner ribs are provided circumferentially along the inner edge of the case, thereby enabling the inner portion of the case to be firmly reinforced.

The case includes one frame portion and the other frame portion facing each other, and includes a plurality of terminal blocks which are provided on each of the one frame portion and the other frame portion,

in which the inner ribs include first inner ribs and second inner ribs,

in which the first inner ribs are respectively provided on the one frame portion and the other frame portion to connect adjacent inner ends of adjacent terminal blocks, and

in which each of the second inner ribs is provided to connect, in a circumferential manner, another inner end other than the adjacent inner ends of the terminal blocks on the one frame portion, and another inner end other than the adjacent inner ends of the terminal blocks on the other frame portion.

The outer ribs include first outer ribs and second outer ribs,

in which the first outer ribs are respectively provided on the one frame portion and the other frame portion to connect adjacent outer ends of adjacent terminal blocks, and
in which each of the second outer ribs is provided on at least one of the one frame portion and the other frame portion to extend from another outer end other than the adjacent outer ends of the terminal blocks.

The second outer rib extends in a bent manner from the above-described other outer end to reach the second inner rib. This makes it possible to firmly reinforce the outer portion of the case.

The second outer rib has a parallel portion and a bent portion,

in which the parallel portion extends from the above-described other outer end, and

in which the bent portion extends from the parallel portion and is bent at an obtuse angle to reach the second inner rib. As a result, the obtuse-angled bent portion becomes effective, thereby enabling the outer portion of the case to be reinforced more firmly.

The intermediate ribs include first intermediate ribs and second intermediate ribs,

in which the first intermediate ribs are respectively provided on the one frame portion and the other frame portion to connect adjacent intermediate ends of adjacent terminal blocks, and

in which each of the second intermediate ribs is provided on at least one of the one frame portion and the other frame portion to connect another intermediate end other than the adjacent intermediate ends of the terminal blocks and the bent portion of the second outer rib. As a result, the first intermediate rib and the second intermediate rib become effective, thereby enabling the case to be reinforced more firmly.

A through hole is provided between the ribs, allowing visual observation of a surface of the substrate through the through hole.

The terminal block has a first hole and a second hole,

in which the first hole is a hole for receiving a fastener;

in which the second hole is an elongated hole for insertion of a terminal; and

in which a width dimension in a longitudinal direction of the second hole is greater than a hole diameter of the first hole. As a result, an effect of suppressing warpage of the case by the above-mentioned ribs becomes relatively greater.

That is, when the width dimension in the longitudinal direction of the second hole is greater than the hole diameter of the first hole, warpage of the case becomes relatively greater as compared with a case where the width dimension in the longitudinal direction of the second hole is equal to or smaller than the hole diameter of the first hole. However, by providing the above-described ribs, the effect of suppressing warpage of the case becomes relatively greater.

The ratio of the width dimension in the longitudinal direction of the second hole to the hole diameter of the first hole is, for example, 1.1 to 3.0.

## EFFECTS OF THE INVENTION

As described above, according to the present invention, by providing the plurality of ribs extending from the ends of the terminal block, the case can be reinforced and warpage can be suppressed.

## BRIEF DESCRIPTION OF THE DRAWINGS

FIG. 1 is a plan view showing a configuration of a semiconductor module according to an embodiment of the present invention.

FIG. 2 is a front view showing the configuration of the semiconductor module.

FIG. 3 is a bottom view showing the configuration of the semiconductor module.

FIG. 4 is an enlarged plan view showing a terminal block of the semiconductor module.

FIG. 5 is a plan view showing a configuration of a semiconductor module according to a first modification of the present invention.

FIG. 6 is a plan view showing a configuration of a semiconductor module according to a second modification of the present invention.

FIG. 7 is a plan view showing a configuration of a semiconductor module according to a third modification of the present invention.

FIG. 8 is a plan view showing a configuration of a semiconductor module according to a fourth modification of the present invention.

FIG. 9 is a plan view showing a configuration of a semiconductor module according to a fifth modification of the present invention.

FIG. 10 is a plan view showing a configuration of a semiconductor module according to a sixth modification of the present invention.

FIG. 11 is a plan view showing a configuration of a semiconductor module according to a seventh modification of the present invention.

FIG. 12 is a plan view showing a configuration of a semiconductor module according to an eighth modification of the present invention.

FIG. 13 is a plan view showing a configuration of a semiconductor module according to a ninth modification of the present invention.

FIG. 14 is a plan view showing a configuration of a semiconductor module according to a tenth modification of the present invention.

FIG. 15 is a plan view showing a configuration of a semiconductor module according to an eleventh modification of the present invention.

## MODE FOR CARRYING OUT THE INVENTION

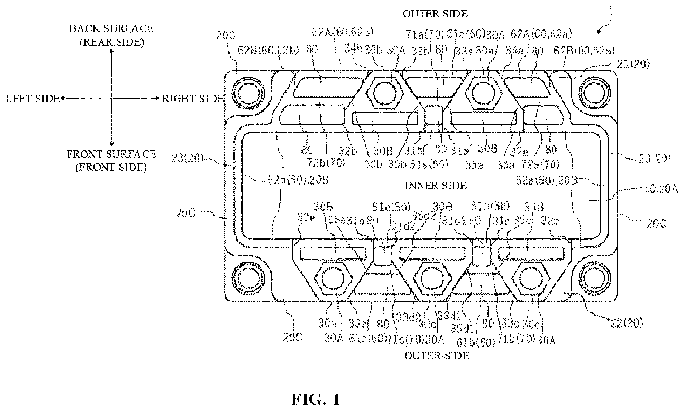

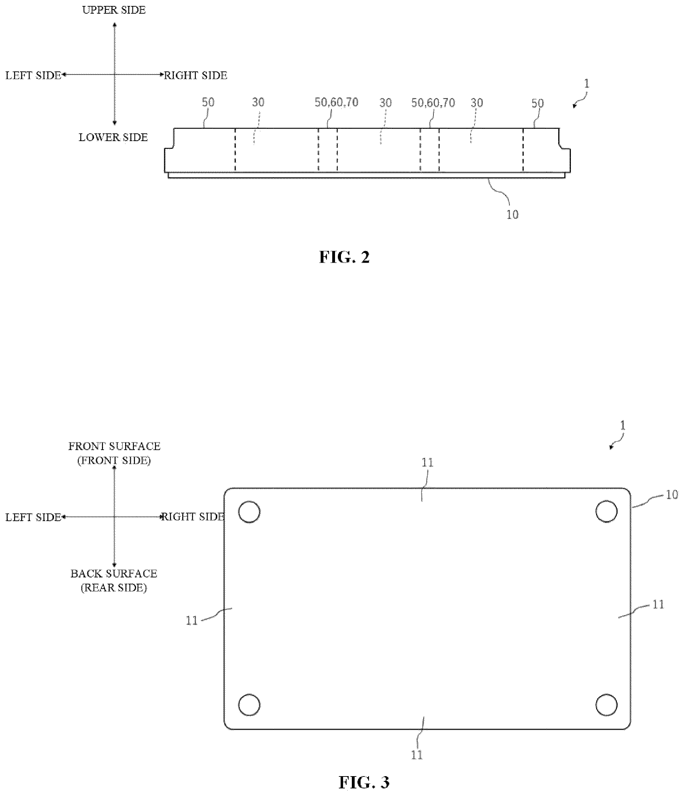

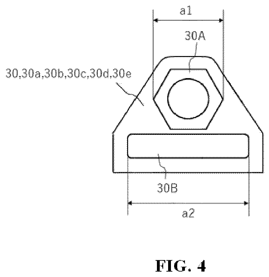

The embodiments of the present invention will be described in detail below with reference to the drawings. FIG. 1 is a plan view showing a configuration of a semiconductor module according to an embodiment of the present invention. FIG. 2 is a front view showing the configuration of the semiconductor module. FIG. 3 is a bottom view showing the configuration of the semiconductor module. FIG. 4 is an enlarged plan view showing a terminal block of the semiconductor module. The front-back, left-right, and top-bottom directions shall be clearly indicated in each figure.

Referring to FIGS. 1 to 4, a configuration of a semiconductor module 1 according to an embodiment of the present invention will be described. The semiconductor module 1 is a semiconductor module in which a case 20 is attached in an annular manner around an edge 11 of a substrate 10. The case 20 has terminal blocks 30 and ribs 50, 60, 70. A plurality of the ribs 50, 60, 70 are provided to extend from the terminal blocks 30. The semiconductor module 1 is formed by attaching the case 20 to the substrate 10. The inside of the case 20 is sealed with resin. The substrate 10 has a rectangular shape. Electronic components (not shown) are mounted on a surface of the substrate 10.

The case 20 is substantially rectangular and annular in shape, and has a frame-like structure. The case 20 is provided with a plurality of terminal blocks 30 on each of one frame portion 21 and the other frame portion 22, which face each other. More specifically, the case 20 is provided with an opening 20A on its inner side, and the plurality of terminal blocks 30 are provided on each of the one frame portion 21 and the other frame portion 22 facing each other across the opening 20A. The surface of the substrate 10 can be visually observed through the opening 20A. The terminal blocks 30 are provided on the one frame portion 21 and the other frame portion 22 so that their positions are alternately arranged. The one frame portion 21 and the other frame portion 22 are connected via connecting portions 23.

Each of the terminal blocks 30 is provided to protrude upward from the case 20 and includes a plate-shaped terminal (not shown).

The terminal block 30 has a hexagonal shape. The terminal block 30 has a first hole 30A and a second hole 30B. The first hole 30A is a hole in which a fastener is provided. The second hole 30B is an elongated hole into which the terminal is inserted. A width dimension $a2$ in the longitudinal direction of the second hole 30B is greater than a hole diameter $a1$ of the first hole 30A. The first hole 30A is a hole into which the fastener is fitted. As shown in Mathematical Formula 1 below, a ratio $A$ of the width dimension $a2$ in the longitudinal direction of the second hole 30B to the hole diameter $a1$ of the first hole 30A is in the range of 1.1 to 3.0.

### [Mathematical Formula 1]

$$A = a2/a1$$

The first hole 30A is provided closer to the outer side in the terminal block 30 and the second hole 30B is provided closer to the inner side in the terminal block 30.

The ribs 50, 60, 70 are provided so as to protrude upward from the case 20. Upward protrusion amounts of the terminal block 30 and each of the ribs 50, 60, and 70 are the same.

The ribs 50, 60, 70 have at least one of a plurality of inner ribs 50, a plurality of outer ribs 60, and a plurality of intermediate ribs 70. The plurality of inner ribs 50 are provided at an inner edge 20B of the case 20 to extend from ends 31, 32 of the terminal block 30. The plurality of outer ribs 60 are provided at outer edge 20C of the case 20 to extend from ends 33, 34 of the terminal block 30. The plurality of intermediate ribs 70 are provided to extend from intermediate ends 35, 36 of the terminal block 30 (in the present embodiment, the ribs 50, 60, 70 include all of the plurality of inner ribs 50, the plurality of outer ribs 60, and the plurality of intermediate ribs 70).

The inner ribs 50 are provided circumferentially along the inner edge 20B of the case 20.

The inner ribs 50 include first inner ribs 51 (50) and second inner ribs 52 (50). The first inner ribs 51 (50) are respectively provided on the one frame portion 21 and the other frame portion 22 to connect adjacent inner ends 31 of adjacent terminal blocks 30.

More specifically, the first inner ribs 51 (50) include:

a rib 51a (50, 51) that is provided so as to connect an inner left end 31a (31) of the terminal block 30a (30) located on the right end side of the one frame portion 21, and an inner right end 31b (31) of the terminal block 30b (30) located on the left end side of the one frame portion 21;

a rib 51b (50, 51) that is provided so as to connect an inner left end 31c (31) of the terminal block 30c (30) located on the right end side of the other frame portion 21, and an inner right end 31d1 (31) of the terminal block 30d (30) located in an intermediate position of the other frame portion 21; and

a rib 51c (50, 51) that is provided so as to connect an inner left end 31d2 (31) of the terminal block 30d (30) located in the intermediate position of the other frame portion 21, and an inner right end 31e (31) of the terminal block 30e (30) located on the left end side of the other frame portion 21.

Each of the second inner ribs 52 (50) is provided to connect, in a circumferential manner, another inner end 32 other than the adjacent inner ends 31 of the terminal blocks 30 of the one frame portion 21 and another inner end 32 other than the adjacent inner ends 31 of the terminal blocks 30 of the other frame portion 22.

More particularly, the second inner ribs 52 (50) include a right side circumferential rib 52a (50, 52) and a left side circumferential rib 52b (50, 52).

In other words, the right side circumferential rib 52a (50, 52) is provided so as to connect, in a circumferential manner, an inner right end 32a (32) of the terminal block 30a (30) on the right end side of the one frame portion 21 and an inner right end 32c (32) of the terminal block 30c (30) on the right end side of the other frame portion 22.

The left side circumferential rib 52b (50, 52) is provided so as to connect, in a circumferential manner, an inner left end 32b (32) of the terminal block 30b (30) on the left end side of the one frame portion 21 and an inner left end 32e (32) of the terminal block 30e (30) on the left end side of the other frame portion 22.

The outer ribs 60 include first outer ribs 61 (60) and second outer ribs 62 (60). The first outer ribs 61 (60) are respectively provided on the one frame portion 21 and the other frame portion 22 to connect adjacent outer ends 33 of adjacent terminal blocks 30. Each of the second outer ribs 62(60) is provided on at least one of the one frame portion 21 and the other frame portion 22 to extend from another outer end 34 other than the adjacent outer ends 33 of the terminal blocks 30 (in the present embodiment, the second outer rib 62 (60) is provided on the one frame portion 21 to extend from the above-described other outer end 34 other than the adjacent outer ends 33 of the terminal blocks 30).

More specifically, the first outer ribs 61 (60) include:

a rib 61a (60, 61) provided so as to connect an outer left end 33a (33) of the terminal block 30a (30) on the right end side of the one frame portion 21 and an outer right end 33b (33) of the terminal block 30b (30) on the left end side of the one frame portion 21;

a rib 61b (60, 61) provided so as to connect an outer left end 33c (33) of the terminal block 30c (30) on the right end side of the other frame portion 21 and an outer right end 33d1 (33) of the terminal block 30d (30) on an intermediate portion of the other frame portion 21; and

a rib 61c (60, 61) provided so as to connect an outer left end 33d2 (33) of the terminal block 30d (30) on the intermediate portion of the other frame portion 21 and an outer right end 33e (33) of the terminal block 30e (30) on the left end side of the other frame portion 21.

The second outer ribs 62 (60) include a rib 62a (60, 62) that is provided so as to extend from an outer right end 34a (34) of the terminal block 30a (30) located on the right end side of the one frame portion 21, and a rib 62b (60, 62) that is provided so as to extend from an outer left end 34b (34) of the terminal block 30a (30) located on the left end side of the one frame portion 21.

Here, each of the second outer ribs 62 (60) extends in a bent manner so as to reach the second inner rib 52 (50) from the above-described other outer end 34. More specifically, the rib 62a (60, 62) of the second outer rib 62 (60) extends in a bent manner so as to reach the right circumferential rib 52a (50, 52) from the outer right end 34a (34) of the terminal block 30a (30) located on the right end side of the one frame portion 21. Further, the rib 62b (60, 62) extends in a bent manner so as to reach the left side circumferential rib 52b (50, 52) from the outer left end 34b (34) of the terminal block 30a (30) located on the left end side of the one frame portion 21.

The second outer rib 62 (60) has a parallel portion 62A (60, 62) and a bent portion 62B (60, 62). The parallel portion 62A (60, 62) is provided to extend from the above-described other outer end 34. More particularly, the parallel portion 62A (60, 62) is provided to extend from the outer right end 34a (34) of the terminal block 30a (30) located on the right end side of the one frame portion 21. The bent portion 62B (60, 62) extends from an end of the parallel portion 62A (60, 62) and is bent at an obtuse angle to reach the second inner rib 52a (50, 52), 52b (50, 52). The parallel portion 62A (60, 62) is provided so as to be parallel to the second inner rib 52a (50, 52), 52b (50, 52).

The intermediate ribs 70 include first intermediate ribs 71 (70) and second intermediate ribs 72 (70). The first intermediate ribs 71 (70) are respectively provided on the one frame portion 21 and the other frame portion 22 to connect adjacent intermediate ends 35 of adjacent terminal blocks 30. Each of the second intermediate ribs 72 (70) is provided on at least one of the one frame portion 21 and the other frame portion 22 to connect another intermediate end 36 other than the adjacent intermediate ends 35 of the terminal blocks 30, and the bent portion 62B (60, 62) of the second outer rib 62 (60) (in the present embodiment, the second intermediate rib 72 (70) is provided on the one frame portion 21 to connect another intermediate end 36 other than the adjacent intermediate ends 35 of the terminal blocks 30, and the bent portion 62B (60, 62) of the second outer rib 62 (60)).

More specifically, the first intermediate ribs 71 (70) include:

a rib 71a (70, 71) that is provided so as to connect an intermediate left end 35a (35) of the terminal block 30a (30) located on the right end side of the one frame portion 21 and an intermediate right end 35b (35) of the terminal block 30b (30) located on the left end side of the one frame portion 21;

a rib 71b (70, 71) that is provided so as to connect an intermediate left end 35c (35) of the terminal block 30c (30) located on the right end side of the other frame portion 21 and an intermediate right end 35d1 (35) of the block 30d (30) located on the intermediate portion of the other frame portion 21; and

a rib 71c (70, 71) that is provided so as to connect an intermediate left end 35d2 (35) of the terminal block 30d (30) located on the intermediate portion of the other frame portion 21 and an intermediate right end 35e (35) of the terminal block 30e (30) located on the left end side of the other frame portion 21.

Further, the second intermediate ribs 72 (70) include:

a rib 72a (70, 72) that is provided so as to connect a right intermediate end 36a (36) of the terminal block 30a (30) located on the right end side of the one frame portion 21 and the bent portion 62B (60, 62) of the second outer rib 62 (60), and

a rib 72b (70, 72) that is provided so as to connect a left intermediate end 36b (36) of the terminal block 30a (30) located on the left end side of the one frame portion 21 and the bent portion 62B (60, 62) of the second outer rib 62 (60).

Furthermore, the first intermediate rib 71 (70) is provided so as to be parallel to the first inner rib 51 (50) and the first outer rib 61 (60). The second intermediate rib 72 (70) is provided so as to be parallel to the second inner rib 52 (50) and the parallel portion 62A (60, 62) of the second outer rib 62 (60).

It is to be noted that through holes 80 are provided between the ribs 50, 60, and 70. The through holes 80 penetrate the case 20 from the upper side to the lower side. The through holes 80 are provided between the first inner rib 51 (50) and the first intermediate rib 71 (70), between the first intermediate rib 71 (70) and the first outer rib 61 (60), between the second inner rib 52 (50) and the second intermediate rib 72 (70), and between the second intermediate rib 72 (70) and the parallel portion 62A (60, 62) of the second outer rib 62 (62). In other words, the through holes 80 are provided between all of the ribs that are arranged in parallel with each other. By providing the through holes 80 between the ribs 50, 60, and 70, the surface of the substrate 10 can be visually observed through the through holes 80. This makes it possible to check the state of the sealing resin on the rear side of the case 20.

As described above, according to the present embodiment, by providing the plurality of ribs 50, 60, and 70 so as to extend from the terminal block 30, the case can be reinforced, and warpage of the case can be suppressed.

Further, the ribs 50, 60, and 70 include at least one of the plurality of inner ribs 50, the plurality of outer ribs 60, and the plurality of intermediate ribs 70. The plurality of inner ribs 50 are provided so as to extend from the ends 31 and 32 of the terminal block 30 at the inner edge 20B of the case 20. The plurality of outer ribs 60 are provided so as to extend from the ends 33 and 34 of the terminal block 30 at the outer edge 20C of the case 20. The plurality of intermediate ribs 70 are provided so as to extend from the intermediate ends 35 and 36 of the terminal block 30. With this configuration, at least one of the inner portion, the outer portion, and the intermediate portion of the case can be reinforced.

Furthermore, the inner ribs 50 are provided along the inner edge 20B of the case 20 so as to extend in a circumferential manner, whereby the inner portion of the case 20 can be firmly reinforced.

Furthermore, the second outer rib 62 extends in a bent manner from the above-described other outer end 34 to reach the second inner rib 52, whereby the outer portion of the case 20 can be firmly reinforced.

Furthermore, the second outer rib 62 includes the parallel portion 62A and the bent portion 62B. The parallel portion 62A is provided so as to extend from the above-described other outer end 34. The bent portion 62B extends from the parallel portion 62A so as to bend at an obtuse angle and reaches the second inner rib 52. Accordingly, the obtuse-angled bent portion 62B becomes effective, and the outer portion of the case 20 can be further firmly reinforced.

Moreover, the intermediate ribs 70 include the first intermediate ribs 71 and the second intermediate ribs 72. The first intermediate ribs 71 are respectively provided on the one frame portion 21 and the other frame portion 22 so as to connect the adjacent intermediate ends 35 of the adjacent terminal blocks 30. Each of the second intermediate ribs 72 is provided on at least one of the one frame portion 21 and the other frame portion 22 so as to connect the above-described other intermediate end 36, which is different from the adjacent intermediate ends 35 of the terminal blocks 30, and the bent portion 62B of the second outer rib 62. Accordingly, the first intermediate rib 71 and the second intermediate rib 72 become effective, and the reinforcement of the case 20 can be further firmly performed.

Here, in the present embodiment, the terminal block 30 includes the first hole 30A and the second hole 30B. The first hole 30A is a hole in which a fastener is provided, and the second hole 30B is an elongated hole into which a terminal is inserted. The width dimension a2 in the longitudinal direction of the second hole 30B is greater than the hole diameter a1 of the first hole 30A. Accordingly, the effect of suppressing warpage of the case 20 by the ribs 50, 60, and 70 described above becomes relatively greater.

That is, in a case where the width dimension a2 in the longitudinal direction of the second hole 30B is greater than the hole diameter a1 of the first hole 30A, warpage of the case 20 becomes relatively greater as compared to a case where the width dimension a2 in the longitudinal direction of the second hole 30B is equal to or smaller than the hole diameter a1 of the first hole 30A. However, by providing the above-described ribs 50, 60, and 70, the effect of suppressing the warpage of the case 20 becomes relatively greater. In recent years, the amount of information processing has become enormous, resulting in increased current flow. As a result, the size of terminals has increased, and it has become more common that the width dimension a2 in the longitudinal direction of the second hole 30B is greater than the hole diameter a1 of the first hole 30A (conventionally, the width dimension a2 in the longitudinal direction of the second hole 30B was often equal to or smaller than the hole diameter a1 of the first hole 30A.)

In the present embodiment, the through holes 80 are provided between all of the ribs that are arranged in parallel with each other, and warpage of the case 20 tends to be relatively greater. However, the warpage of the case 20 can be reduced by the effect of the above-described ribs 50, 60, and 70.

It is noted that the present invention is not limited to the above-described embodiment, and various modifications and applications can be made within the scope of the invention described in the claims.

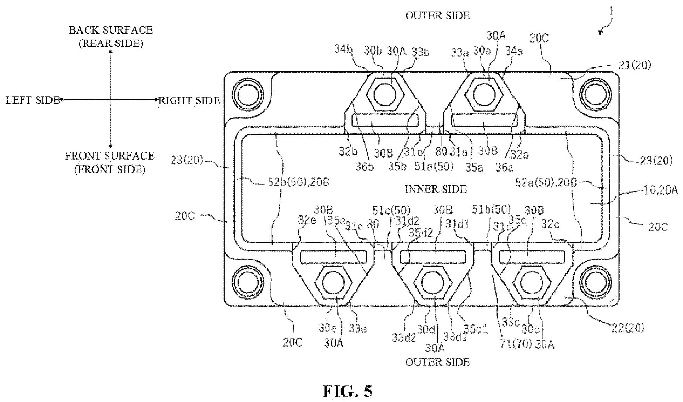

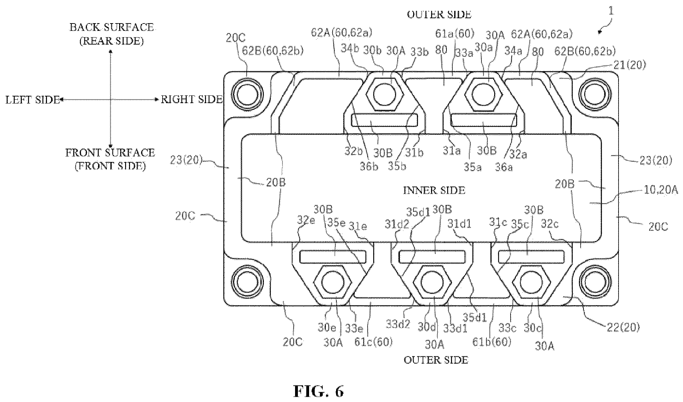

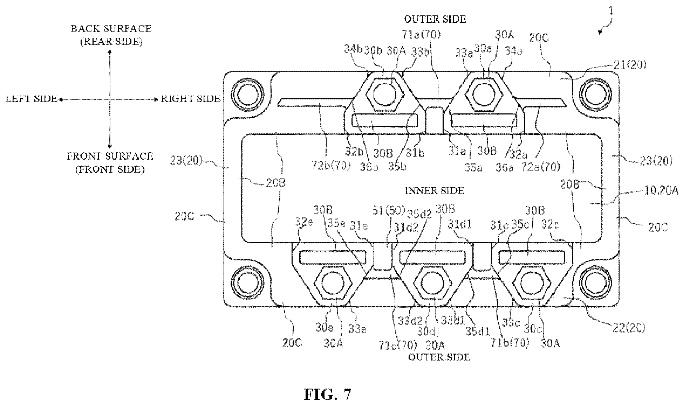

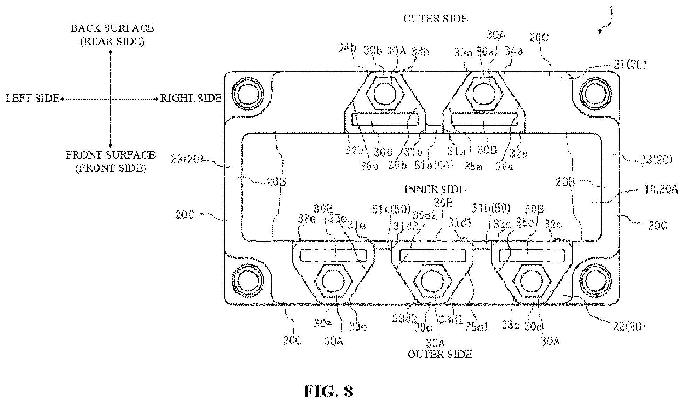

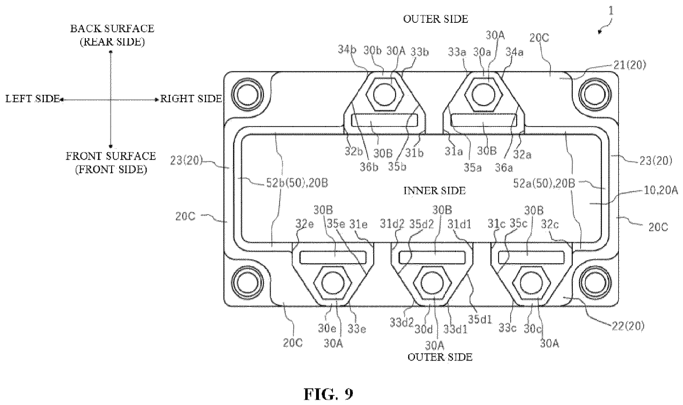

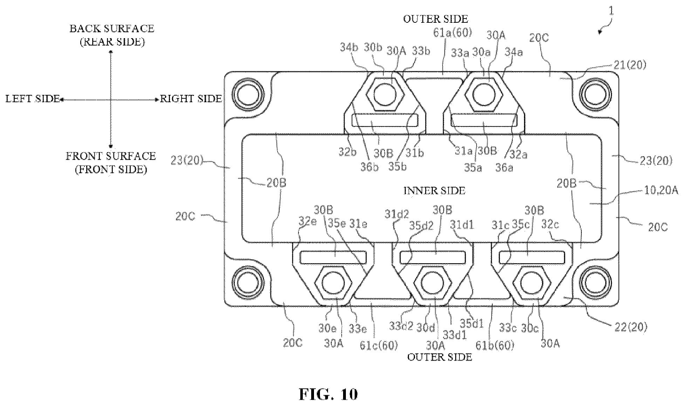

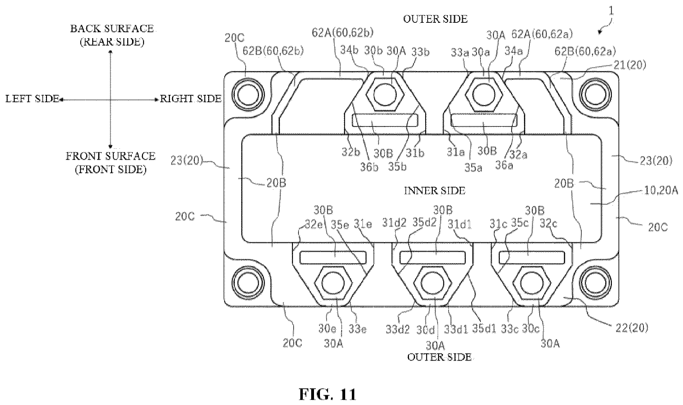

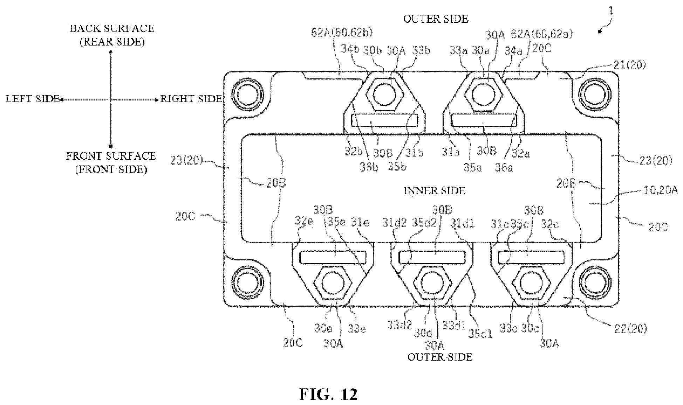

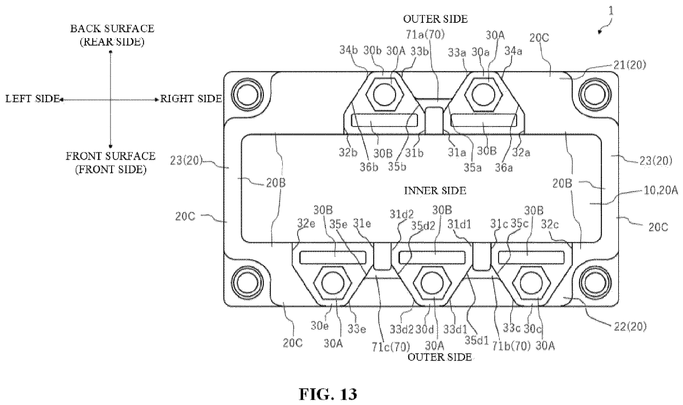

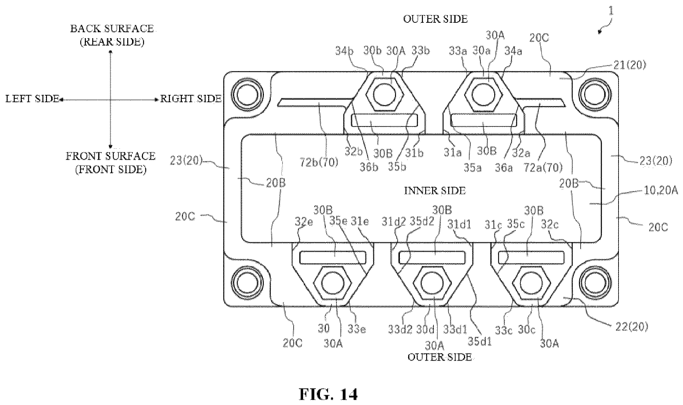

That is, in the above-described embodiment, the ribs 50, 60, and 70 include all of the plurality of inner ribs 50, the plurality of outer ribs 60, and the plurality of intermediate ribs 70. However, as shown in FIG. 5, the ribs may include only the inner ribs 50. As shown in FIG. 6, the ribs may include only the outer ribs 60. As shown in FIG. 7, the ribs may include only the intermediate ribs 70. Each of the modifications still achieves the required effect. Further, the inner ribs 50 may include only the first inner ribs 51 as shown in FIG. 8, or only the second inner ribs 52 as shown in FIG. 9. Each of the modifications still achieves the required effect. Furthermore, the outer ribs 60 may include only the first outer ribs 61 as shown in FIG. 10, or only the second outer ribs 62 as shown in FIG. 11. Each of the modifications still achieves the required effect. Moreover, each of the second outer ribs 62 may include only the parallel portion 62A as shown in FIG. 12. This modification still achieves the required effect. In addition, the intermediate ribs 70 may include only the first intermediate ribs 71 as shown in FIG. 13, or only the second intermediate ribs 72 as shown in FIG. 14. Each of the modifications still achieves the required effect. Also, the required effect can be achieved by appropriately combining the ribs 50, 60, and 70 shown in FIGS. 5 to 14. That is, the ribs 50, 60, and 70 achieve the required effect as long as they are provided so as to extend from the terminal block 30.

However, it is a more preferable embodiment that the ribs 50, 60, and 70 include all of the inner ribs 50, the outer ribs 60, and the intermediate ribs 70;

in which the inner ribs 50 include both the first inner ribs 51 and the second inner ribs 52;

in which the outer ribs 60 include both the first outer ribs 61 and the second outer ribs 62;

in which each of the second outer ribs 62 includes both the parallel portion 62A and the bent portion 62B; and

in which the intermediate ribs 70 include both the first intermediate ribs 71 and the second intermediate ribs 72.

In the above-described embodiment, the through holes 80 are provided between all of the parallel ribs. However, the present invention is not limited to such an embodiment, and the required effect can also be achieved by providing the through holes 80 between only some of the parallel ribs.

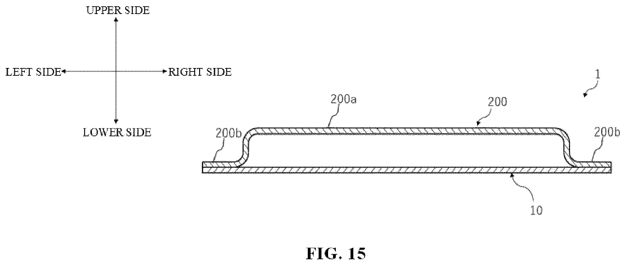

Further, in the above-described embodiment, the semiconductor module 1 includes the case 20 attached in an annular manner around the edge 11 of the substrate 10. The case 20 has the substantially rectangular annular shape, forming the frame shape with the opening 20A on the inner side. However, as shown in FIG. 15, the case 200 includes a dome-shaped main body 200a that covers the inner opening 20A, and its annular frame portion 200b is mounted so as to surround the edge 11 of the substrate 10. In this embodiment as well, the effect of the present invention can be achieved.

## EXPLANATION OF REFERENCE NUMERALS

A: Ratio
a1: Hole diameter
a2: Width dimension
1: Semiconductor module
10: Substrate
11: Edge
20: Case
20A: Opening
20B: Edge
21: One frame portion
22: The other frame portion
23: Connecting portion

30, 30a, 30b, 30c, 30d, 30e: Terminal block
30A: First hole
30B: Second hole
31, 31a, 31b, 31c, 31d1, 31d2, 31e, 32, 32a, 32b, 32c, 32e, 33, 33a, 33b, 33c, 33d1,
33d2, 33e, 34, 34a, 34b, 35, 35a, 35b, 35c, 35d1, 35d2, 35e, 36, 36a, 36b: End
50: Inner rib (rib)
51: First inner rib
51a, 51b, 51c: Rib
52: Second inner rib
52a: Right side circumferential rib
52b: Left side circumferential rib
60: Outer rib (rib)
61: First outer rib
61a, 61b, 61c: Rib
62: Second outer rib
62a, 62b: Rib
62A: Parallel portion
62B: Bent portion
70: Intermediate rib (rib)
71: First intermediate rib
71a, 71b, 71c: Rib
72: Second intermediate rib
72a, 72b: Rib
80: Through hole
200: Case
200a: Case body
200b: Frame portion

**Claims**

1. A semiconductor module having a case and a substrate, the case being attached in an annular manner around an edge of the substrate,

   wherein the case has a terminal block and ribs, and
   wherein a plurality of the ribs are provided on the case to extend from the terminal block.

2. The semiconductor module according to claim 1, wherein the ribs include at least one of a plurality of inner ribs, a plurality of outer ribs, and a plurality of intermediate ribs,

   wherein the plurality of inner ribs are provided at an inner edge of the case to extend from inner ends of the terminal block,
   wherein the plurality of outer ribs are provided at an outer edge of the case to extend from outer ends of the terminal block, and
   wherein the plurality of intermediate ribs are provided to extend from intermediate ends of the terminal block.

3. The semiconductor module according to claim 2, wherein the inner ribs are provided circumferentially along the inner edge of the case.

4. The semiconductor module according to claim 3, wherein the case includes one frame portion and the other frame portion facing each other, and includes a plurality of terminal blocks which are provided on each of the one frame portion and the other frame portion,

   wherein the inner ribs include first inner ribs and second inner ribs,
   wherein the first inner ribs are respectively provided on the one frame portion and the other frame portion to connect adjacent inner ends of adjacent terminal blocks, and
   wherein each of the second inner ribs is provided to connect, in a circumferential manner, another inner end other than the adjacent inner ends of the terminal blocks on the one frame portion, and another inner end other than the adjacent inner ends of the terminal blocks on the other frame portion.

5. The semiconductor module according to claim 2, wherein the outer ribs include first outer ribs and second outer ribs,

   wherein the first outer ribs are respectively provided on the one frame portion and the other frame portion to connect adjacent outer ends of adjacent terminal blocks, and
   wherein each of the second outer ribs is provided on at least one of the one frame portion and the other frame portion to extend from another outer end other than the adjacent outer ends of the terminal blocks.

6. The semiconductor module according to claim 5, wherein the second outer rib extends in a bent manner from the other outer end to reach the second inner rib.

7. The semiconductor module according to claim 6, wherein the second outer rib has a parallel portion and a bent portion,

   wherein the parallel portion extends from the other outer end, and
   wherein the bent portion extends from the parallel portion and is bent at an obtuse angle to reach the second inner rib.

8. The semiconductor module according to claim 2 wherein the intermediate ribs include first intermediate ribs and second intermediate ribs,

   wherein the first intermediate ribs are respectively provided on the one frame portion and the other frame portion to connect adjacent intermediate ends of adjacent terminal blocks, and wherein each of the second intermediate ribs is provided on at least one of the one frame portion and the other frame portion to connect another intermediate end other than the adjacent intermediate ends of the terminal blocks and the bent portion of the second outer rib.

9. The semiconductor module according to claim 1, wherein a through hole is provided between the ribs.

10. The semiconductor module according to claim 1, wherein the terminal block has a first hole and a second hole, wherein the first hole is a hole for receiving a fastener; wherein the second hole is a slotted hole for insertion of a terminal; and wherein the width dimension of the second hole in the longitudinal direction is larger than the diameter of the first hole.

11. The semiconductor module according to claim 10, wherein the ratio of the diameter of the first hole to the longitudinal width of the second hole is between 1.1 and 3.0.

FIG. 1

UPPER SIDE

LEFT SIDE ←——→ RIGHT SIDE

LOWER SIDE

50    30    50,60,70    30    50,60,70    30    50    1

10

**FIG. 2**

FRONT SURFACE
(FRONT SIDE)

LEFT SIDE ←——→ RIGHT SIDE

BACK SURFACE
(REAR SIDE)

11    10

11    11

11

**FIG. 3**

30,30a,30b,30c,30d,30e

a1

30A

30B

a2

**FIG. 4**

OUTER SIDE

BACK SURFACE
(REAR SIDE)

LEFT SIDE ◄────────► RIGHT SIDE

FRONT SURFACE
(FRONT SIDE)

INNER SIDE

OUTER SIDE

**FIG. 5**

FIG. 6

**FIG. 7**

FIG. 8

FIG. 9

BACK SURFACE
(REAR SIDE)

LEFT SIDE ←-------→ RIGHT SIDE

FRONT SURFACE
(FRONT SIDE)

OUTER SIDE

INNER SIDE

OUTER SIDE

**FIG. 10**

BACK SURFACE
(REAR SIDE)

LEFT SIDE ←——→ RIGHT SIDE

FRONT SURFACE
(FRONT SIDE)

OUTER SIDE

INNER SIDE

OUTER SIDE

FIG. 11

FIG. 12

FIG. 13

FIG. 14

UPPER SIDE

LEFT SIDE ← → RIGHT SIDE

LOWER SIDE

200a  200  1

200b  200b

10

FIG. 15

## INTERNATIONAL SEARCH REPORT

| International application No. |
| --- |
| **PCT/JP2024/008710** |

**A. CLASSIFICATION OF SUBJECT MATTER**

***H01L 25/07***(2006.01)i; ***H01L 23/28***(2006.01)i
FI: H01L25/04 C; H01L23/28 K

According to International Patent Classification (IPC) or to both national classification and IPC

**B. FIELDS SEARCHED**

Minimum documentation searched (classification system followed by classification symbols)

H01L25/07; H01L23/28

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2020-27891 A (FUJI ELECTRIC CO., LTD.) 20 February 2020 (2020-02-20) paragraphs [0013]-[0052], fig. 1-6 | 1-3, 9-11 |
| A | | 4-8 |
| X | JP 2001-53220 A (FUJI ELECTRIC CO., LTD.) 23 February 2001 (2001-02-23) paragraphs [0010]-[0023], fig. 1-4 | 1-3, 10-11 |
| A | | 4-9 |
| A | WO 2021/256092 A1 (FUJI ELECTRIC CO., LTD.) 23 December 2021 (2021-12-23) | 1-11 |
| A | WO 2012/131976 A1 (TOYOTA JIDOSHA KABUSHIKI KAISHA) 04 October 2012 (2012-10-04) | 1-11 |
| A | JP 2018-46158 A (FUJI ELECTRIC CO., LTD.) 22 March 2018 (2018-03-22) | 1-11 |
| A | JP 2021-9970 A (SUMITOMO ELECTRIC IND., LTD.) 28 January 2021 (2021-01-28) | 1-11 |
| A | JP 2015-23226 A (MITSUBISHI ELECTRIC CORP.) 02 February 2015 (2015-02-02) | 1-11 |

☑ Further documents are listed in the continuation of Box C.  ☑ See patent family annex.

| | |
| --- | --- |
| \* Special categories of cited documents: <br> "A" document defining the general state of the art which is not considered to be of particular relevance <br> "D" document cited by the applicant in the international application <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
| --- | --- |
| **25 April 2024** | **14 May 2024** |

| Name and mailing address of the ISA/JP | Authorized officer |
| --- | --- |
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (July 2022)

**INTERNATIONAL SEARCH REPORT**

| International application No. |
| --- |
| **PCT/JP2024/008710** |

| C. | DOCUMENTS CONSIDERED TO BE RELEVANT | |
| --- | --- | --- |
| Category* | Citation of document, with indication, where appropriate, of the relevant passages | Relevant to claim No. |
| A | JP 7-142658 A (FUJI ELECTRIC CO., LTD.) 02 June 1995 (1995-06-02) | 1-11 |
| A | CD-ROM of the specification and drawings annexed to the request of Japanese Utility Model Application No. 055484/1992 (Laid-open No. 011356/1994) (NIHON INTER ELECTRONICS CORPORATION) 10 February 1994 (1994-02-10) | 1-11 |

Form PCT/ISA/210 (second sheet) (July 2022)

## INTERNATIONAL SEARCH REPORT
### Information on patent family members

International application No.

**PCT/JP2024/008710**

| Patent document cited in search report | | | Publication date (day/month/year) | Patent family member(s) | | | Publication date (day/month/year) |
|---|---|---|---|---|---|---|---|
| JP | 2020-27891 | A | 20 February 2020 | US | 2020/0051892 | A1 | |
| | | | | paragraphs [0023]-[0063], fig. 1-6 | | | |
| | | | | JP | 6493612 | B1 | |
| | | | | DE | 102019120130 | A1 | |
| | | | | CN | 110828405 | A | |
| JP | 2001-53220 | A | 23 February 2001 | US | 6396125 | B1 | |
| | | | | columns 2-4, fig. 1-4 | | | |
| | | | | GB | 2356489 | A | |
| | | | | DE | 10036619 | A1 | |
| WO | 2021/256092 | A1 | 23 December 2021 | US | 2022/0301954 | A1 | |
| | | | | CN | 114730742 | A | |
| WO | 2012/131976 | A1 | 04 October 2012 | US | 2014/0015313 | A1 | |
| | | | | EP | 2693625 | A1 | |
| | | | | CN | 103460587 | A | |
| JP | 2018-46158 | A | 22 March 2018 | US | 2018/0076053 | A1 | |
| | | | | CN | 107818955 | A | |
| JP | 2021-9970 | A | 28 January 2021 | (Family: none) | | | |
| JP | 2015-23226 | A | 02 February 2015 | (Family: none) | | | |
| JP | 7-142658 | A | 02 June 1995 | (Family: none) | | | |
| JP | 06-011356 | U1 | 10 February 1994 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008153313 A